# EUROPÄISCHE PATENTSCHRIFT

(11) **EP 2 215 657 B1**
(45) Veröffentlichungstag und Bekanntmachung des Hinweises auf die Patenterteilung: **10.07.2013**
(21) Anmeldenummer: 08854905.0
(22) Anmeldetag: 18.11.2008
(51) Int. Cl.: H01L 25/075, H01L 33/00, H01L 33/50, H01L 33/58

(54) **ANORDNUNG MIT MINDESTENS ZWEI LICHTEMITTIERENDEN HALBLEITERBAUELEMENTEN UND HERSTELLUNGSVERFAHREN DAFÜR**
ARRANGEMENT HAVING AT LEAST TWO LIGHT-EMITTING SEMICONDUCTOR DEVICES AND METHOD FOR MANUFACTURING THE SAME
ASSEMBLAGE COMPORTANT AU MOINS DEUX DISPOSITIFS SEMI-CONDUCTEURS LUMINESCENTS ET SON PROCÉDÉ DE FABRICATION

(30) Priorität: 27.11.2007 DE 102007056925; 26.02.2008 DE 102008011153
(43) Veröffentlichungstag der Anmeldung: 11.08.2010
(73) Patentinhaber: OSRAM Opto Semiconductors GmbH, 93055 Regensburg (DE)
(72) Erfinder: SINGER, Frank, 93128 Regenstauf (DE); ZEILER, Thomas, 93152 Nittendorf (DE); REILL, Joachim, 93197 Zeitlarn (DE)
(74) Vertreter: Epping - Hermann - Fischer
(86) Internationale Anmeldenummer: PCT/DE2008/001902
(87) Internationale Veröffentlichungsnummer: WO 2009/067989

(56) Entgegenhaltungen:
- WO-A-2006/098561
- WO-A-2006/129278
- WO-A-2007/114614
- JP-A- 2007 129 188
- US-A1- 2006 001 055
- US-A1- 2006 197 098
- US-A1- 2007 166 853

## Beschreibung

Die Erfindung betrifft eine Anordnung mit mindestens zwei lichtemittierenden Halbleiterbauelementen und ein Verfahren zur Herstellung einer Anordnung mit mindestens zwei lichtemittierenden Halbleiterbauelementen.

Um mit Hilfe von lichtemittierenden Halbleiterbauelementen weißes Licht zu erzeugen, werden die lichtemittierende Halbleiterbauelemente mit einer Umhüllung versehen, die eine Konvertersubstanz enthält. Diese Konvertersubstanz konvertiert die vom Halbleiterbauelement emittierte Strahlung eines ersten Wellenlängenbereichs (Primärstrahlung) in Strahlung eines zweiten Wellenlängenbereichs (Sekundärstrahlung), der sich von dem ersten Bereich unterscheidet. Weißes Licht kann auf diese Art entweder erzeugt werden, indem Primärstrahlung mit der Sekundärstrahlung gemischt wird, oder indem die Farbanteile der konvertierten Strahlung zusammengemischt weißes Licht ergeben.

Wenn mehrere lichtemittierende Halbleiterbauelemente mit Konverterumhüllung benachbart angeordnet werden, kann es durch die Strahlung benachbarter lichtemittierender Bauelemente zu einer Anregung der Konvertersubstanz von Halbleiterbauelementen kommen, an die keine Spannung angelegt ist. Dieses Mitleuchten führt dazu, dass Anwendungen, die eine genaue Trennung zwischen hellen und dunklen Bereichen benötigen, nur mit hohem Aufwand realisiert werden können.

In der Druckschrift US 2006/0197098 A1 ist ein Licht emittierendes Bauelement beschrieben, bei dem zwei Licht emittierende Bereiche jeweils mit einem LED-chip und einer Umhüllung, die eine Konvertersubstang enthält, optisch durch eine Partitionierung voneinander getrennt sind.

Aus der Druckschrift US 2007/0166853 A1 ist eine LED-Anordnung bekannt, bei der phosphorkonvertierten LED-Chips in einem Gehäuse aus einer strahlungsabsorbierenden Vergussmasse angeordnet sind.

In der Druckschrift WO 2007/114614 A1 ist ein Bauelement beschrieben, bei dem ein Substrat mehrere Kavitäten für Licht emittierende Bereiche aufweist. Auf dem Boden der Kavitäten sind phosphorkonvertierten LED-Chips angeordnet, wobei die Kavitäten vergossen sind. Die Licht emittierende Bereiche sind optisch durch eine Partitionerung voneinander getrennt. Das Bauelement kann eine lichtdurchlässige, flache Abdeckung umfassen.

Es ist eine Aufgabe der Erfindung, eine Anordnung mit mindestens zwei lichtemittierenden Halbleiterbauelementen sowie ein verfahren zur Herstellung einer Anordnung mit mindestens zwei lichtemittierenden Halbleiterbauelementen anzugeben, das sich einfacher und kostengünstiger herstellen lässt.

Die Aufgaben wird gelöst durch eine Anordnung mit den Merkmalen des Anspruchs 1 beziehungsweise ein Verfahren mit den Merkmalen des Anspruchs 8.

Eine Anordnung mit mindestens zwei benachbart zueinander angeordneten lichtemittierenden Halbleiterbauelementen weist Umhüllungen auf, die jeweils die mindestens zwei lichtemittierenden Halbleiterbauelemente zumindest teilweise umgeben. In den Umhüllungen ist eine Konvertersubstanz enthalten, die den Wellenlängenbereich der von den Halbleiterbauelementen emittierten Strahlung teilweise oder vollständig konvertiert. Die Anordnung weist mindestens ein optisches Dämpfelement auf, das zwischen den mindestens zwei lichtemittierenden Halbleiterbauelementen angeordnet ist. Das Dämpfelement isoliert die jeweiligen Umhüllungen optisch, um eine optische Einkopplung einer von mindestens einem der Halbleiterbauelemente emittierten Strahlung in die Umhüllung mindestens eines der anderen Halbleiterbauelemente zu verringern. Das Dämpfelement kann auch die optische Einkopplung einer von mindestens einer der Umhüllungen emittierten Strahlung in mindestens eine andere der Umhüllungen verringern.

Das optische Dämpfelement ist als Teil einer lichtdurchlässigen Abdeckung, die zum Schutz der Halbleiterbauelemente über den Halbleiterbauelementen angeordnet ist, gebildet.

In einer Ausführungsform wird ein Siliziumstreifen, der so hoch ist, dass er die Umhüllungen optisch isoliert mit der Abdeckung verbunden, beispielsweise durch eine anodische Bondverbindung.

In einer weiteren Ausführungsform wird ein Körper aus einem gespritzten Kunststoff mit der Abdeckung verbunden, beispielsweise auf die Abdeckung geklebt oder gedruckt.

Das Dämpfelement kann eine Ausformung der Abdeckung sein, die mit der Abdeckung aus einem Stück ausgebildet ist. Diese Ausformung ist mit einer lichtundurchlässigen Beschichtung versehen, die beispielsweise chromhaltig ist.

In einer Ausführungsform, die nicht Teil der vorliegenden Erfindung ist, ist das Dämpfelement als Erhöhung eines Trägerelements für die mindestens zwei lichtemittierenden Halbleiterbauelemente ausgebildet. Beispielsweise sind das Trägerelement und das Dämpfelement aus einem Stück gebildet, beispielsweise aus einer Keramik. Das Dämpfelement kann, um ein Durchstrahlen durch die Erhöhung zu verringern, mit einem lichtundurchlässigen Material beschichtet sein, beispielsweise galvanisch mit einer Metallschicht. Die Erhöhung des Trägerelements reicht mindestens bis in die Höhe der Umhüllung, um diese optisch zu isolieren.

In einer weiteren Ausführungsform, die ebenfalls nicht Teil der vorliegenden Erfindung ist, ist das Dämpf-element als Körper aus einem Vergussmaterial ausgebildet, der die mindestens zwei Halbleiterbauelemente und die jeweiligen Umhüllungen umgibt und die Umhüllungen optisch isoliert. Das Dämpfelement kann ein Körper aus einem Kunststoff sein, der die mindestens zwei Halbleiterbauelemente und die jeweiligen Umhüllungen umgibt und die Umhüllungen optisch isoliert.

Bei einem Verfahren zum Herstellen einer Anordnung mit mindestens zwei benachbart angeordneten lichtemittierenden Halbleiterbauelementen werden Umhüllungen, die jeweils die zwei lichtemittierenden Halbleiterbauelemente zumindest teilweise umgeben, vorgesehen. In den Umhüllungen ist eine Konvertersubstanz enthalten, die den Wellenlängenbereich der von den Halbleiterbauelementen emittierten Strahlung teilweise oder vollständig konvertiert. Zwischen die zwei lichtemittierenden Halbleiterbauelementen wird mindestens ein optisches Dämpfelement eingebracht. Das Dämpfelement isoliert die jeweiligen Umhüllungen optisch, um eine optische Einkopplung einer von mindestens einem der Halbleiterbauelemente emittierten Strahlung in die Umhüllung mindestens eines der anderen Halbleiterbauelemente zu verringern. Das Dämpfelement kann auch die optische Einkopplung einer von mindestens einer der Umhüllungen emittierten Strahlung in mindestens eine andere der Umhüllungen verringern. Das Verfahren umfasst ein Bereitstellen einer lichtdurchlässigen Abdeckung zum Schutz der mindestens zwei Halbleiterbauelemente, ein Ausbilden mindestens eines optischen Dämpfelements an der Abdeckung und ein Anordnen der Abdeckung, so dass das mindestens eine optische Dämpfelement zwischen den mindestens zwei lichtemittierenden Halbleiterbauelementen liegt, um die jeweiligen Umhüllungen optisch zu isolieren. Beispielsweise wird das optische Dämpfelement durch anodisches Bonden mit der Abdeckung verbunden.

Das Verfahren kann ein Ätzen des Trägerelements aus einer mit der Abdeckung verbundenen Siliziumschicht beinhalten.

Das optische Dämpfelement kann auf die Abdeckung geklebt oder gedruckt werden. In einer weiteren Ausführungsform wird die Abdeckung mit mindestens einer Ausbildung geprägt, und diese Ausbildung mit einem lichtundurchlässigen Material beschichtet.

Das Verfahren kann ein Aufbringen der lichtemittierenden Halbleiterbauelemente auf ein Trägerelement umfassen. Das Dämpfelement ist so hoch, dass es die Umhüllungen optisch isoliert und hat eine Form, die ein Positionieren der mindestens zwei Halbleiterbauelemente im geringen Abstand zueinander ermöglicht.

In einer Ausführungsform, die nicht Teil der vorliegenden Erfindung ist, wird das optische Dämpfelement und das Trägerelement als ein Stück gebildet und beide werden aus dem gleichen Material hergestellt. In einer weiteren Ausführungsform, die ebenfalls nicht Teil der vorliegenden Erfindung ist, umfasst das Verfahren ein Siebdrucken eines Vergussmaterials zwischen die mindestens zwei lichtemittierenden Halbleiterbauelemente. Das Verfahren kann ein Umspritzen der lichtemittierenden Halbleiterbauelemente mit einem Kunststoff aufweisen, so dass der Kunststoff die Umhüllung optisch isoliert.

Weitere Merkmale, Vorteile und Weiterbildungen ergeben sich aus den nachfolgenden in Verbindung mit den Figuren 1 bis 13C erläuterten Beispielen.

Es zeigen:
- Figur 1: eie schematische Darstellung einer Anordnung die ein Prinzip der vorliegenden Erfindung darstellt,
- Figur 2: eine schematische Darstellung eines lichtemittierenden Halbleiterbauelements,
- Figur 3: eine schematische Darstellung, die nicht Teil der vorliegenden Erfindung ist, eines Trägerelements mit einem Dämpfelement,
- Figur 4: eine schematische Darstellung einer Anordnung gemäß einer Ausführungsform, die nicht Teil der vorliegenden Erfindung ist, mit einem Körper aus vergussmaterial,
- Figur 5: eine schematische Darstellung einer Anordnung gemäß einer Ausführungsform, die ebenfalls nicht Teil der vorliegenden Erfindung ist, mit einem Kunststoffkörper,
- Figur 6: eine schematische Darstellung eines Trägerelements sowie einer lichtdurchlässigen Abdeckung, an der ein Dämpfelement angeordnet ist, gemäß einer Ausführungsform der vorliegenden Erfindung,
- Figur 7: eine schematische Darstellung einer lichtdurchlässigen Abdeckung, auf die ein Dämpfelement aufgebracht ist, gemäß einer Ausführungsform der vorliegenden Erfindung,
- Figur 8: eine schematische Darstellung einer lichtdurchlässigen Abdeckung, die zusammen mit einer Ausformung geprägt ist, gemäß einer Ausführungsform der vorliegenden Erfindung,
- Figuren 9A bis 9D: eine schematische Darstellung eines Ausführungsbeispiels, das nicht Teil der vorliegenden Erfindung ist, für ein Verfahren zum Umgießen von Halbleiterbauelementen mit Umhüllungen,
- Figuren 10A bis 10C: eine schematische Darstellung eines Verfahrens, das nicht Teil der vorliegenden Erfindung ist, bei dem ein Dämpfelement auf einem Träger-element angeordnet wird,
- Figuren 11A und 11B: eine schematische Darstellung eines Ausführungsbeispiels für ein Siebdruckverfahren, das nicht Teil der vorliegenden Erfindung ist,
- Figuren 12A bis 12C: eine schematische Darstellung eines Ausführungsbeispiels für ein Verfahren gemäß der vorliegenden Erfindung, bei dem das optische Dämpfelement auf einer lichtdurchlässigen Abdeckung angeordnet wird, und
- Figuren 13A bis 13C: eine schematische Darstellung eines Ausführungsbeispiels eines Ätzverfahrens gemäß der vorliegenden Erfindung.

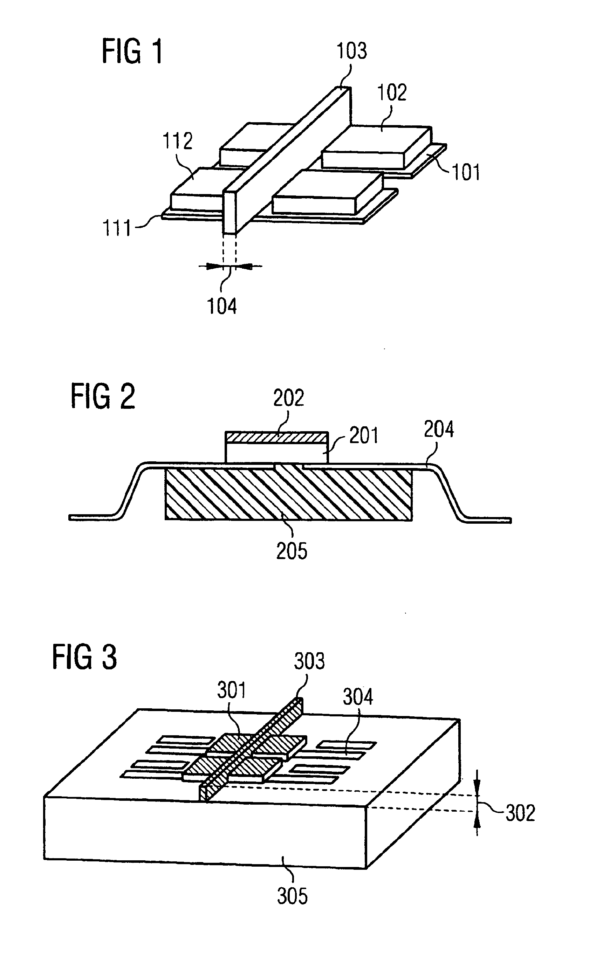

Figur 1 zeigt lichtemittierende Halbleiterbauelemente 101 und 111, Umhüllungen der lichtemittierenden Halbleiterbauelemente, die Fluoreszenzkonverterschichten 102 und 112 bilden und ein optisches Dämpfelement 103. Die Halbleiterbauelemente emittieren bei Anlegen einer Spannung Strahlung in einem bestimmten Wellenlängenbereich. Die Umhüllungen enthalten ein Konvertermaterial, das, wenn es durch elektromagnetische Strahlung eines bestimmten Wellenlängenbereichs angeregt wird, Strahlungen bestimmter Wellenlängen emittiert. Das Konvertermaterial kann mindestens einen Leuchtstoff enthalten. Als Leuchtstoff eignen sich beispielsweise anorganische oder organische Leuchtstoffe.

Die Wellenlängenbereiche der anregenden und der emittierten Strahlung unterscheiden sich. Die Umhüllung kann entweder die gesamte auf sie eintreffende Strahlung umwandeln, sie kann auch nur einen Teil der eintreffenden Strahlung konvertieren und den übrigen Teil durchlassen, ohne den Wellenlängenbereich der durchgelassenen Strahlung signifikant zu beeinflussen.

Das Dämpfelement dient zur optischen Trennung der Umhüllungen oder der Umhüllungen und der Halbleiterbauelemente. Es ist für die Wellenlängenbereiche, die von den Halbleiterbauelementen und den Umhüllungen emittiert wird, möglichst undurchlässig.

In dem gezeigten Beispiel ist das Dämpfelement zwischen zwei Reihen von Halbleiterbauelementen mit jeweiligen Umhüllungen angeordnet und verhindert weitestgehend, dass durch die emittierte Strahlung benachbart angeordneter Halbleiterbauelemente und/oder deren Konverterschichten Konvertermaterial in Umhüllungen angeregt wird, an deren dazugehörigen Halbleiterbauelementen keine Spannung angelegt ist.

Es können eine Vielzahl weiterer Dämpfelemente zwischen weiteren Reihen angeordnet sein, um die weiteren Reihen optisch voneinander zu isolieren. Das Dämpfelement kann auch gitterförmig ausgebildet sein, so dass jedes Halbleiterbauelement mit jeweiligen Umhüllungen von den übrigen benachbarten Halbleiterbauelementen und deren Umhüllungen im Wesentlichen optisch getrennt ist. Das Dämpfelement kann auch so ausgebildet sein, dass Felder von lichtemittierenden Halbleiterbauelementen mit jeweiligen Umhüllungen voneinander getrennt werden.

Eine Breite 104 des Dämpfelements ist möglichst gering, damit die Halbleiterbauelemente nahe aneinander angeordnet werden können. Dies hat ein homogen wirkendes Leuchtbild der Anordnung zur Folge. Auch ein relativ hoher Kontrast zwischen Halbleiterbauelementen, die Strahlung emittieren, und Halbleiterbauelementen, an die keine Spannung angelegt ist, kann erreicht werden. Der Kontrastwert liegt möglichst über 100:1, beispielsweise bei 200:1.

Figur 2 zeigt eine schematische Darstellung eines lichtemittierenden Halbleiterbauelements 201, eine Fluoreszenzkonverterschicht 202, elektrische Leitungen 204 und ein Trägerelement 205. Die Fluoreszenzkonverterschicht ist auf dem lichtemittierenden Halbleiterbauelement angeordnet, so dass von dem Halbleiterbauelement emittierte Strahlung konvertiert werden kann. Das Halbleiterbauelement ist auf dem Trägerelement angeordnet und elektrisch leitend mit den Leitungen verbunden.

Über die Leitungen kann an dem Halbleiterbauelement eine Spannung angelegt werden. Die von dem Halbleiterbauelement bei angelegter Spannung emittierte Strahlung liegt in einer Ausführungsform im blauen Farbbereich, beispielsweise bei 445 nm. Die Konvertersubstanz ist durch die von dem lichtemittierenden Halbleiterbauelement emittierte Primärstrahlung anregbar und emittiert eine Sekundärstrahlung. In einer Ausführungsform liegt der Wellenlängenbereich der Sekundärstrahlung im gelben Farbbereich, also zwischen 560 und 590 nm. Die Konvertersubstanz kann in einer weiteren Ausführungsform Strahlung emittieren, die in unterschiedlichen Wellenlängenbereichen liegt, beispielsweise im roten (625 bis 740 nm) und im grünen (520 bis 560 nm) Farbbereich.

Die Primärstrahlung und die Sekundärstrahlung weisen unterschiedliche Wellenlängenbereiche auf. Ein Teil der Primärstrahlung wird ohne Wellenlängenkonversion durch die Konvertersubstanz durchgelassen. Die Primärstrahlung und die Sekundärstrahlung mischen sich additiv. Ein gewünschter resultierender Farbort, beispielsweise weiß, kann beispielsweise durch ein Einstellen eines Mischungsverhältnisses der Primärstrahlung und Sekundärstrahlung eingestellt werden. Die Konvertersubstanz kann auch die gesamte Primärstrahlung umwandeln. In diesem Fall besteht die Sekundärstrahlung aus Strahlung unterschiedlicher Wellenlängen, die zusammengemischt den gewünschten Farbort ergeben.

Strahlung im blauen Farbbereich gemischt mit Strahlung im gelben Farbbereich ergibt weißes Licht. Strahlung im roten Farbbereich gemischt mit Strahlung im grünen Farbbereich ergibt gelbes Licht. Strahlung im blauen, roten und grünen Farbbereich ergibt gemischt weißes Licht.

Das Trägerelement kann zum Ableiten der im lichtemittierenden Halbleiterbauelement entstehenden Wärme dienen. Dazu ist es aus einem ausreichend gut wärmeleitenden Material gefertigt, beispielsweise einer Keramik.

Figur 3, die nicht Teil der vorliegenden Erfindung ist, zeigt lichtemittierende Halbleiterbauelemente mit Umhüllungen, die Fluoreszenzkonverterschichten 301 enthalten, ein optisches Dämpfelement 303, elektrische Leitungen 304 und ein Trägerelement 305. Die Halbleiterbauelemente sind auf dem Trägerelement angeordnet und können über die Leitungen mit Spannung versorgt werden. Das Dämpfelement ist in einem Stück mit dem Trägerelement gebildet. Dazu wird beim Herstellen des Trägerelements an der Stelle zwischen den Halbleiterbauelementen eine Erhöhung des Trägerelements gebildet. Um das gewünschte enge Raster der Halbleiterbauelemente zu erreichen, ist diese Erhöhung möglichst dünn ausgebildet. Die Erhöhung kann, um die optische Dämpfwirkung zu erhöhen, mit einem lichtundurchlässigen Material beschichtet sein, beispielsweise kann eine Metallschicht galvanisch aufgebracht sein.

In der gezeigten Ausführungsform, die nicht Teil der vorliegenden Erfindung ist, trennt die Erhöhung des Trägerelements zwei Zeilen von Halbleiterbauelementen. Das Dämpfelement kann aber auch so ausgebildet sein, dass jedes Halbleiterbauelement mit jeweiliger Umhüllung von den übrigen benachbarten Halbleiterbauelementen und deren Umhüllungen optisch getrennt ist. Das Dämpfelement kann auch so ausgebildet sein, dass bestimmte Felder von Halbleiterbauelementen optisch voneinander getrennt werden. Eine Höhe 302 des Dämpfelements ist mindestens so hoch, dass die lichtemittierenden Halbleiterbauelemente mit den jeweiligen Umhüllungen ausreichend voneinander isoliert werden, also keine Fluoreszenzkonverterschichten ungewollt angeregt werden.

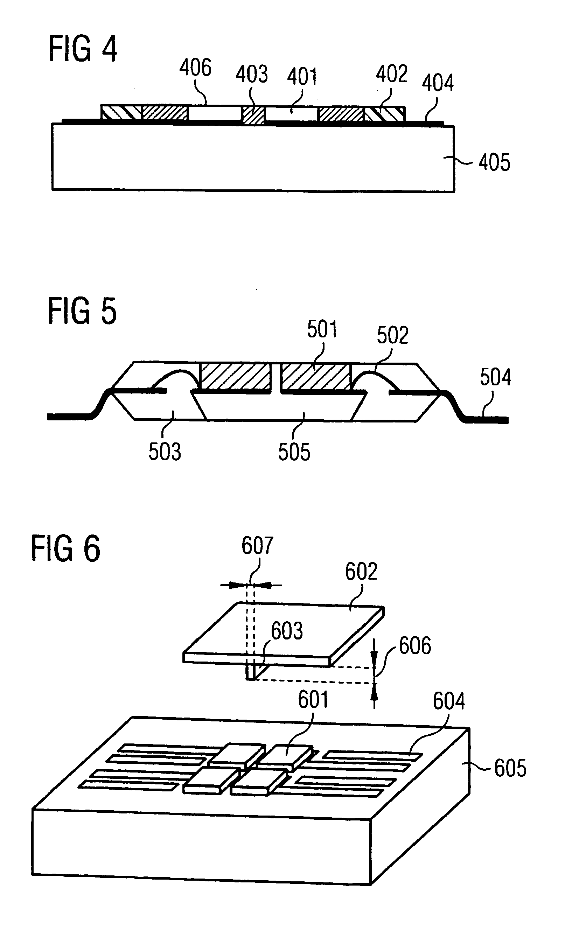

Figur 4, die nicht Teil der vorliegenden Erfindung ist, zeigt lichtemittierende Halbleiterbauelemente 401 mit, Umhüllungen, einen Rahmen 402, Vergussmaterial 403, elektrische Leitungen 404 und ein Trägerelement 405. Die Umhüllungen enthalten Fluoreszenzkonverterschichten. Die Halbleiterbauelemente sind auf dem Trägerelement angeordnet und können über die Leitungen mit einer Spannung versorgt werden. Der Rahmen ist um einen Bereich gebildet, in dem die Halbleiterbauelemente angeordnet sind. Der Rahmen dient dazu Bereiche von dem Vergussmaterial freizuhalten, die nicht von dem Vergussmaterial bedeckt werden sollen.

Das Vergussmaterial bedeckt den Bereich innerhalb des Rahmens so hoch, dass die lichtemittierenden Halbleiterbauelemente und die entsprechenden Umhüllungen mit Fluoreszenzkonvertermaterial optisch isoliert sind, maximal jedoch bis auf eine Höhe einer Oberfläche 406 der lichtemittierenden Halbleiterbauelemente und der Umhüllungen, aus der Strahlung emittiert wird.

Zusätzlich zum möglichst lichtundurchlässigen Vergusskörper kann über den lichtemittierenden Halbleiterbauelementen und der Vergussmasse auf der Seite der Oberfläche 406 ein lichtdurchlässiger Verguss zum Schutz der Halbleiterbauelemente aufgebracht sein. Der Rahmen muss in diesem Fall so hoch ausgebildet sein, dass sich das lichtdurchlässige Vergussmaterial nur innerhalb des Rahmens ausbreitet und Bereiche von dem lichtdurchlässige Vergussmaterial freigehalten sind, die nicht von dem Vergussmaterial bedeckt werden sollen.

Figur 5, die nicht Teil der vorliegenden Erfindung ist, zeigt lichtemittierende Halbleiterbauelemente mit Umhüllungen, Bonddrähte 502, einen Gehäusekörper 503, elektrische Leitungen 504 und ein Trägerelement 505. Die Umhüllungen enthalten Fluoreszenzkonverterschichten. Die Halbleiterbauelemente mit den Fluoreszenzkonverterschichten sind auf dem Trägerelement angeordnet und können über die Leitungen und die Bonddrähte mit Spannung versorgt werden. Der Gehäusekörper ist beispielsweise aus möglichst lichtundurchlässigem Kunststoff und umgibt die lichtemittierenden Halbleiterbauelemente, die Fluoreszenzkonverterschichten, das Trägerelement und teilweise die Leitungen. Durch die Ausbildung des Gehäusekörpers zwischen den lichtemittierenden Halbleiterbauelementen mit jeweiligen Umhüllungen werden diese optisch voneinander isoliert.

Der Kunststoffkörper erfüllt zusätzlich zum optischen Trennen eine Funktion eines Schutzkörpers. Der Gehäusekörper dient beispielsweise zum Schutz der Leitungen und der Halbleiterbauelemente vor äußeren Einflüssen sowie dazu, die Handhabung der Anordnung, beispielsweise während einer Montage, zu vereinfachen.

Figur 6 zeigt lichtemittierende Halbleiterbauelemente 601 mit Umhüllungen, eine Abdeckung 602, ein optisches Dämpfelement 603, elektrische Leitungen 604 und ein Trägerelement 605 gemäß einer Ausführungsform der vorliegenden Erfindung. Die Umhüllungen enthalten Fluoreszenzkonverterschichten. Die Halbleiterbauelemente sind auf dem Trägerelement angeordnet und können über die Leitungen mit einer Spannung versorgt werden. Die Abdeckung besteht aus einem lichtdurchlässigen Material, beispielsweise Glas, beispielsweise BF33 oder Pyrex, und dient zum Schutz der Halbleiterbauelemente vor äußeren Einflüssen.

Das optische Dämpfelement wird als Teil der Abdeckung angeordnet. In der Figur ist die Abdeckung nicht in ihrer endgültigen Position gezeigt, sondern in größerem Abstand zu den Halbleiterbauelementen und dem Trägerelement. Eine Höhe 606 des Dämpfelements ist so hoch, dass das Dämpfelement, wenn die Abdeckung in ihrer vorgesehenen Position angeordnet ist, eine optische Trennung der Halbleiterbauelemente und der jeweiligen Umhüllungen bewirkt.

In einer Ausführungsform reicht das Dämpfelement bis zwischen die Umhüllungen, in einer weiteren Ausführungsform reicht das Dämpfelement bis zwischen die Umhüllungen und die lichtemittierenden Halbleiterbauelemente. Das Dämpfelement verringert so eine optische Einkopplung einer von mindestens einer der Umhüllungen emittierten Strahlung in mindestens eine andere der Umhüllungen. Das Dämpfelement kann auch die optische Einkopplung einer von mindestens einem der Halbleiterbauelemente emittierten Strahlung in die Umhüllung mindestens eines der anderen Halbleiterbauelemente verringern.

Im gezeigten Ausführungsbeispiel werden durch das optische Dämpfelement zwei Reihen lichtemittierende Halbleiterbauelemente mit Fluoreszenzkonverterschichten von einander isoliert. Es können weitere optische Dämpfelemente angeordnet sein, um mehr als zwei Reihen von Halbleiterbauelementen mit jeweiligen Umhüllungen voneinander zu isolieren.

Das Dämpfelement kann wie in der gezeigten Ausführungsform quaderförmig sein, das Dämpfelement kann auch andere Formen haben, beispielsweise im Querschnitt dreieckig. Die Form ist derart ausgebildet, dass die lichtemittierenden Halbleiterbauelemente möglichst nah aneinander angeordnet seien können. Eine Breite 607 liegt beispielsweise in einem Bereich von 0,05 mm bis 0,3 mm, die Höhe in einem Bereich von 0,2 mm bis 0,8 mm. Das Dämpfelement ist beispielsweise durch eine anodische Bondverbindung mit der Abdeckung verbunden und kann in einer Ausführungsform aus Silizium bestehen.

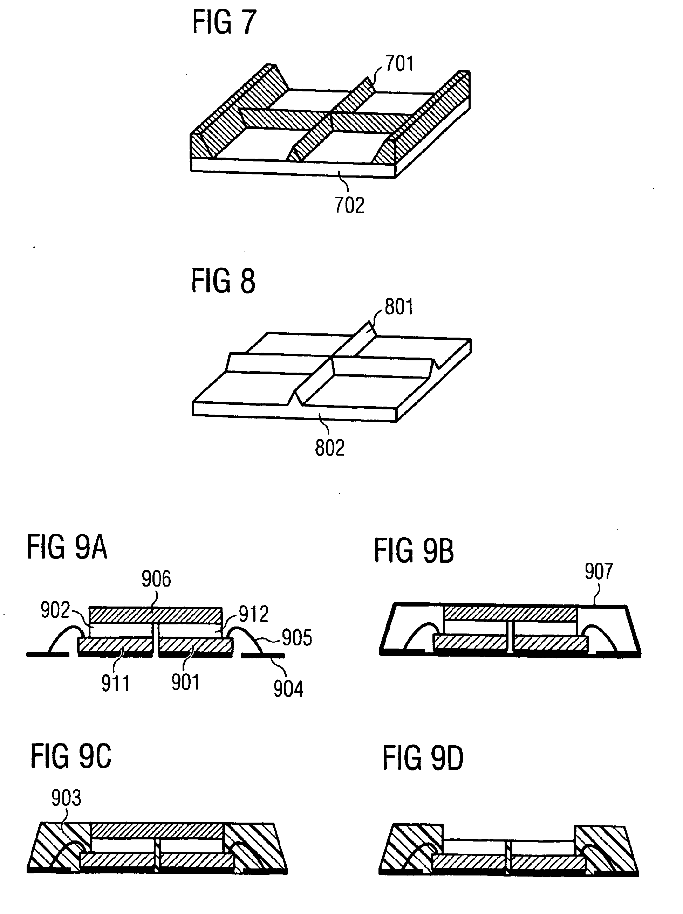

Figur 7 zeigt eine Abdeckung 702 mit einem Trennsteg 701 gemäß einer Ausführungsform des vorliegenden Erfindung. Das Dämpfelement ist gitterförmig ausgebildet, so dass lichtemittierende Halbleiterbauelemente von den benachbarten Halbleiterbauelementen optisch isoliert werden, wenn die Abdeckung in ihrer vorgesehenen Position zum Schutz von Halbleiterbauelementen angeordnet ist. Das Dämpfelement kann auch so ausgebildet sein, dass Reihen von lichtemittierenden Halbleiterbauelementen mit jeweiligen Fluoreszenzkonverterschichten voneinander isoliert werden.

Die Abdeckung ist aus einem lichtdurchlässigen Material gefertigt, beispielsweise Glas. Das Dämpfelement kann aus einer auf die Abdeckung aufgebrachten möglichst lichtundurchlässigen Beschichtung geätzt sein. Beispielsweise ist die möglichst lichtundurchlässige Beschichtung eine Siliziumbeschichtung, die beispielsweise anodisch auf die Abdeckung gebondet ist. In einer anderen Ausführungsform ist das Dämpfelement aus Kunststoff und beispielsweise auf die Abdeckung geklebt oder gedruckt.

Figur 8 zeigt eine beschichtete Ausbildung 801 einer Abdeckung 802 gemäß einer Ausführungsform des vorliegenden Erfindung. Die Abdeckung ist aus lichtdurchlässigem Material gefertigt. Die Ausbildung wird möglichst lichtundurchlässig beschichtet, beispielsweise mit einer Metallstruktur. Die Ausbildung der Abdeckung ist so hoch, dass sie die Umhüllungen der lichtemittierenden Halbleiterbauelemente optisch isoliert, wenn die Abdeckung in ihrer vorgesehenen Position zum Schutz von Halbleiterbauelementen angeordnet ist. Das Dämpfelement ist gitterförmig ausgebildet, so dass lichtemittierende Halbleiterbauelemente von den benachbarten Halbleiterbauelementen optisch isoliert werden. Das Dämpfelement kann auch so ausgebildet sein, dass Reihen von lichtemittierenden Halbleiterbauelementen mit jeweiligen Fluoreszenzkonverterschichten voneinander isoliert werden.

Figur 9A, die nicht Teil der vorliegenden Erfindung ist, zeigt lichtemittierende Halbleiterbauelemente 901 und 911, Umhüllungen mit Fluoreszenzkonverterschichten 902 und 912, Leitungen 904, Bondrähte 905 und ein Schutzelement 906. Die Halbleiterbauelemente mit Fluoreszenzkonverterschichten werden mit einem Leiterrahmen, der aus Leitungen 904 gebildet ist, verbunden, beispielsweise durch Kleben oder Löten. Auf der dem Leiterrahmen entgegen gesetzten Oberfläche der lichtemittierenden Halbleiterbauelemente und den Umhüllungen wird ein Schutzelement, beispielsweise eine Schutzfolie, aufgebracht, die die Halbleiterbauelemente und die Umhüllungen in den folgenden Verfahrensschritten vor Beschädigungen, beispielsweise Verkratzen, schützt.

Figur 9B, die ebenfalls nicht Teil der vorliegenden Erfindung ist, zeigt eine Spritzform 907, die auf einer Seite relativ genau mit dem Schutzelement abschließt, auf einer anderen Seite mit dem Leiterrahmen. Der bei dem Verfahren entstehende Kunststoffkörper kann die lichtemittierenden Halbleiterbauelemente und die jeweiligen Umhüllungen optisch voneinander trennen. Eine den Halbleiterbauelementen gegenüberliegenden Seite des Leiterrahmens sowie die Seite der lichtemittierenden Halbleiterbauelemente, aus der Strahlung emittiert wird, werden nicht von dem Vergussmaterial bedeckt.

Figur 9C, die ebenfalls nicht Teil der vorliegenden Erfindung ist, zeigt einen Kunststoffkörper 903, der die lichtemittierenden Halbleiterbauelemente mit dem jeweiligen Umhüllungen umgibt. Der Kunststoffkörper hat eine Form, die ihm durch die Spritzform vorgegeben wurde und bedeckt weder die den Halbleiterbauelementen gegenüber liegende Seite des Leiterrahmens noch die Oberfläche der Halbleiterbauelemente aus der Strahlung emittiert wird. Der Kunststoffkörper trennt die lichtemittierenden Halbleiterbauelemente und die jeweiligen Umhüllungen optisch voneinander.

Figur 9D, die ebenfalls nicht Teil der vorliegenden Erfindung ist, zeigt die Anordnung, nachdem das Schutzelement entfernt wurde. Dieser Schritt kann entfallen, wenn das Schutzelement ausreichend lichtdurchlässig ist. In diesem Fall kann das lichtdurchlässige Schutzelement in der Anordnung verbleiben.

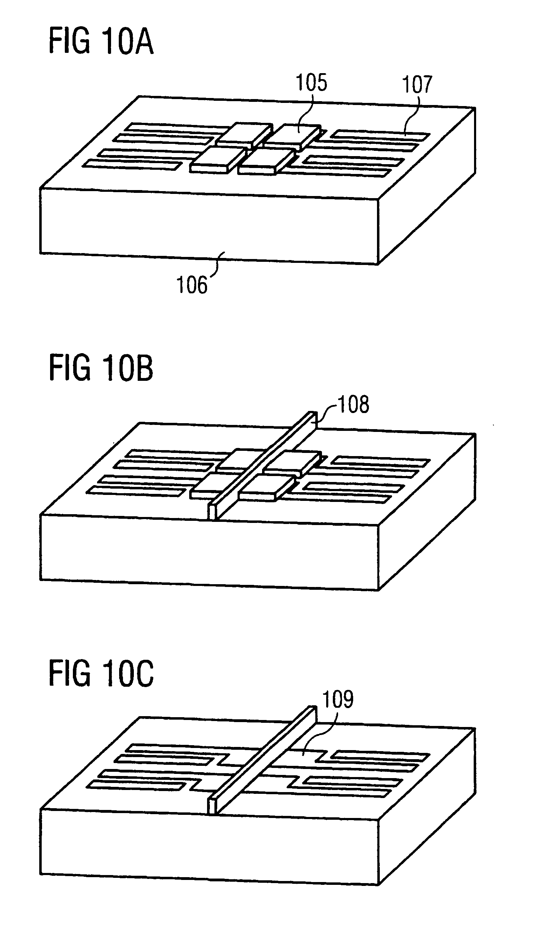

Figur 10A, die ebenfalls nicht Teil der vorliegenden Erfindung ist, zeigt lichtemittierende Halbleiterbauelemente mit Fluoreszenzkonverterschichten 105, ein Trägerelement 106 und elektrische Leitungen 107. Die lichtemittierenden Halbleiterbauelemente mit den Fluoreszenzkonverterschichten werden auf dem Trägerelement aufgebracht. Über die Leitungen kann eine Spannung angelegt werden. In dem Ausführungsbeispiel sind 2 x 2 Halbleiterbauelemente mit jeweiligen Umhüllungen angeordnet. In anderen Ausführungsformen sind Vielzahlen von Halbleiterbauelementen auf dem Trägerelement angeordnet, beispielsweise eine Anordnung von 13 x 66 Halbleiterbauelementen mit jeweiligen Umhüllungen.

In Figur 10B, die ebenfalls nicht Teil der vorliegenden Erfindung ist, ist ein Dämpfelement 108 zwischen den zwei Reihen der lichtemittierten Halbleiterbauelemente mit Fluoreszenzkonverterschichten angeordnet. Das Dämpfelement ist so hoch, dass es die lichtemittierenden Halbleiterbauelemente und die jeweiligen Umhüllungen von einander trennt. In der gezeigten Ausführungsform werden zwei Reihen von lichtemittierenden Halbleiterbauelementen voneinander optisch isoliert. Das Dämpfelement kann auch gitterförmig ausgebildet sein und die Halbleiterbauelemente von ihren jeweiligen Nachbarn optisch isolieren.

Das Dämpfelement kann auf dem Trägerelement angeordnet werden, bevor das Trägerelement mit den lichtemittierenden Halbleiterbauelementen bestückt wird. Ein solches Trägerelement mit Dämpfelement zeigt Figur 10C, die ebenfalls nicht Teil der vorliegenden Erfindungs ist.

Figur 10C zeigt ein Trägerelement mit Leitungen und Chipanschlussflächen 109. Das Dämpfelement ist zwischen den Chipanschlussflächen angeordnet. Wenn auf das Trägerelement Halbleiterbauelemente aufgebracht werden, führt dies zu einer Anordnung, wie in Figur 10B gezeigt. Das Trägerelement und das Dämpfelement können als ein Stück gebildet werden, beispielsweise aus Keramik und daraufhin mit Halbleiterbauelementen bestückt werden.

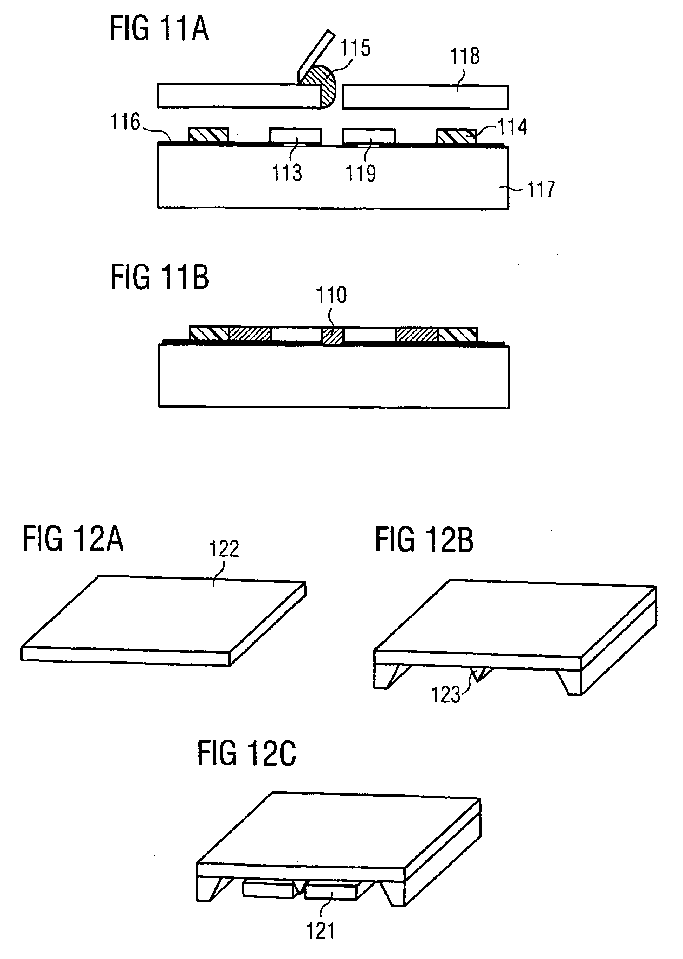

Figur 11A, die ebenfalls nicht Teil der vorliegenden Erfindungs ist, zeigt lichtemittierende Halbleiterbauelemente mit Fluoreszenzkonverterschichten 113, einen Rahmen 114, Vergussmaterial 115, elektrische Leitungen 116, ein Trägerelement 117 und eine Schablone 118. Die Halbleiterbauelemente sind auf dem Trägerelement angeordnet und können über die Leitungen mit Spannung versorgt werden. Der Rahmen ist so auf dem Trägerelement angeordnet, dass er einen Bereich umgibt, der mit dem Vergussmaterial gefüllt werden soll.

Das Vergussmaterial wird mittels Schablonendruck über die Schablone auf das Trägerelement gedruckt. Die Schablone hat dort Löcher, wo Vergussmaterial aufgedruckt werden soll. Das Vergussmaterial breitet sich nach dem Drucken auf dem Trägerelement weiter aus, bis es ausgehärtet ist. Der Rahmen beschränkt das Ausbreiten des Vergussmaterials. Das Vergussmaterial soll eine Oberfläche 119 der Halbleiterbauelemente, aus der Strahlung emittiert wird, nicht bedecken. Durch die über dem Trägerelement angeordnete Schablone wird soviel Vergussmasse gedruckt, dass diese auf dem Trägerelement hoch genug ist, um die Halbleiterbauelemente mit den Fluoreszenzkonverterschichten optisch zu isolieren, die Oberflächen 119 aber nicht bedeckt.

Figur 11B, die ebenfalls nicht Teil der vorliegenden Erfindung ist, zeigt die Anordnung mit einem Vergusskörper 110 aus dem Vergussmaterial 115, dem Trägerelement und den Halbleiterbauelementen mit Umhüllungen. Der Vergusskörper wurde auf die Anordnung gedruckt. Nur die Oberflächen 119 der Halbleiterbauelemente mit Fluoreszenzkonverterschichten, aus denen Strahlung austritt, bleiben frei. Die anderen Flächen werden von dem Vergussmaterial umgeben. Durch den Rahmen wird festgelegt, welche Bereiche auf dem Trägerelement mit Vergussmasse bedeckt werden.

Auf dem Trägerelement können mehrere Rahmen angeordnet sein, um mehrere Vergusskörper auf dem Trägerelement ausbilden zu können. Die Rahmen schließen jeweils einen Bereich ein, in dem der Vergusskörper zur optischen Isolation der in dem Bereich angeordneten lichtemittierenden Halbleiterbauelemente mit Fluoreszenzkonverterschichten gebildet wird.

Figur 12A zeigt eine lichtdurchlässige Abdeckung 122 gemäβ einer Ausführungsform der vorliegenden Erfindung. Die Abdeckung dient zum Schutz einer Anordnung von Halbleiterbauelementen mit Fluoreszenzkonverterschichten vor äußeren Einflüssen. Sie ist lichtdurchlässig, absorbiert und reflektiert also möglichst wenig Strahlung in den Wellenlängenbereichen, in denen die Halbleiterbauelemente und die Fluoreszenzkonverterschichten emittieren.

In einer Ausführungsform liegen die Bereiche der von der Anordnung emittierten Strahlung im sichtbaren Bereich, zwischen etwa 380 nm und 780 nm. Die Abdeckung kann aber auch lichtdurchlässig sein für Strahlung im Infrarotbereich (780 nm bis 1 mm) oder im ultravioletten Bereich (1 nm bis 380 nm). Die Abdeckung kann optische Funktionen erfüllen, beispielsweise kann sie als Linse ausgebildet sein oder Bereiche enthalten, die als Linsen wirken.

Figur 12B zeigt Dämpfelemente 123, gemäß einer Ausführungsform der vorliegenden Erfindung. Diese sind möglichst lichtundurchlässig und an den Stellen der Abdeckung angeordnet, an denen eine optische Trennung von lichtemittierenden Halbleiterbauelementen, die von der Abdeckung bedeckt werden sollen, vorgesehen ist. Die Dämpfelemente werden so ausgebildet, dass die zu bedeckenden Halbleiterbauelemente möglichst nah aneinander angeordnet seien können.

Die Dämpfelemente können beispielsweise durch anodisches Bonden mit der Abdeckung verbunden sein, beispielsweise sind die Dämpfelemente anodisch aufgebondete Siliziumstreifen. In einer anderen Ausführungsform sind die Dämpfelemente auf die Abdeckung geklebt, in einer weiteren Ausführungsform sind die Dämpfelemente auf die Abdeckung gedruckt.

In einer weiteren Ausführungsform sind die Dämpfelemente beim Prägen der Abdeckung als Ausbildung der Abdeckung gebildet worden. Diese Ausbildungen werden mit einem lichtundurchlässigen Material beschichtet, beispielsweise galvanisch mit einer Metallstruktur.

Figur 12C zeigt lichtemittierende Halbleiterbauelemente mit Fluoreszenzkonverterschichten 121, die von einer Abdeckung mit Dämpfelementen bedeckt sind, gemäβ der vorliegenden Erfindung. Die Abdeckung ist so über den Halbleiterbauelementen mit Fluoreszenzkonverterschichten angeordnet, dass die Dämpfelemente zwischen diesen liegen und diese optisch von benachbart angeordneten Halbleiterbauelementen und Fluoreszenzkonverterschichten trennen.

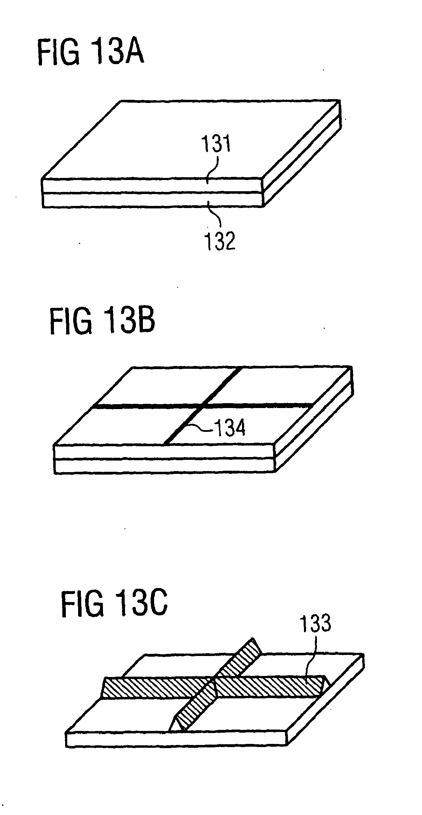

Figur 13A zeigt, gemäß einer Ausführungsform der vorliegenden Erfindung, eine lichtdurchlässige Abdeckung 132 und eine möglichst lichtundurchlässige Schicht 131. Die Abdeckung ist mit der Schicht verbunden. Die Abdeckung ist beispielsweise aus Glas gebildet. Die Schicht ist beispielsweise eine Siliziumschicht, die anodisch auf die Abdeckung gebondet ist.

Figur 13B zeigt eine Ätzmaske 134. Die Ätzmaske dient zur Durchlochätzung und ist so ausgebildet, dass nach einem Ätzprozess Dämpfelemente an den Stellen der Glasabdeckung stehen bleiben, an denen Halbleiterbauelemente mit Fluoreszenzkonverterschichten optisch voneinander isoliert werden sollen.

Die Ätzmaske besteht beispielsweise aus Siliziumoxid (SiO) oder Siliziumnitrid (SiN). Durch eine relativ schmale Maskenstruktur und eine auftretende Unterätzung der Maske, also ein Eindringen des Ätzmaterials unter die Maske, können keilförmige Dämpfelemente gebildet werden. Diese bilden beispielsweise einen Winkel von 54,7° aus. Das Ätzmaterial ist beispielsweise Kaliumhydroxid (KOH) oder Ethylendiaminpyrocatechol (EDP). Die Bereiche der Abdeckung, an denen die Strahlung der Halbleiterbauelemente möglichst ungehindert durch die Abdeckung soll, sind durch das Ätzen von der lichtundurchlässigen Schicht befreit worden.

Figur 13C zeigt, gemäß einer Ausführungsform der vorliegenden Erfindung, die Abdeckung mit einem Dämpfelement 133 nach dem Ätzvorgang. Die Dämpfelemente sind keilförmig an den Stellen gebildet, an denen eine optische Trennung von Halbleiterbauelementen, die von der Abdeckung bedeckt werden sollen, gewünscht ist. Sie sind genügend hoch, um zwischen die Umhüllungen der Halbleiterbauelemente und die Halbleiterbauelemente zu reichen. Sie weisen eine Form auf, die ein nah benachbartes Anordnen der zu bedeckenden Halbleiterbauelemente ermöglicht.

## Patentansprüche

1. Anordnung mit mindestens zwei benachbart zueinander angeordneten lichtemittierenden Halbleiterbauelementen (101, 111, 601), umfassend:
- eine, jeweils die mindestens zwei lichtemittierenden Halbleiterbauelemente zumindest teilweise umgebende Umhüllung (102, 112), in der eine Konvertersubstanz zur teilweisen oder vollständigen Wellenlängenkonversion der von den mindestens zwei lichtemittierenden Halbleiterbauelementen (101, 111) emittierten Strahlung enthalten ist,
- mindestens ein optisches Dämpfelement (103, 603, 701, 801, 123, 133), das zwischen den mindestens zwei lichtemittierenden Halbleiterbauelementen (101, 111) angeordnet ist und
die jeweiligen Umhüllungen (102, 112) optisch isoliert, um eine optische Einkopplung einer von mindestens einem der Halbleiterbauelemente (101) emittierten Strahlung in die Umhüllung (112) mindestens eines der anderen Halbleiterbauelemente (111), oder die optische Einkopplung einer von mindestens einer der Umhüllungen (102) emittierten Strahlung in mindestens eine andere der Umhüllungen (112) zu verringern,
eine lichtdurchlässige Abdeckung (602, 702, 802, 122, 132) zum Schutz der mindestens zwei Halbleiterbauelemente (601),
**dadurch gekennzeichnet, dass** das optische Dämpfelement (103, 603, 701, 801, 123, 133) als Teil der lichtdurchlässigen Abdeckung (602, 702, 802, 122, 132) gebildet ist.

2. Anordnung nach Anspruch 1,
wobei ein Körper aus einem gespritzten Kunststoff mit der Abdeckung verbunden ist.

3. Anordnung nach Anspruch 2,
wobei der Körper auf die Abdeckung geklebt oder gedruckt ist.

4. Anordnung nach Anspruch 1, umfassend mindestens einen Siliziumstreifen (603, 123), der so hoch ist, dass er die Umhüllungen optisch isoliert.

5. Anordnung nach Anspruch 4, umfassend eine anodische Bondverbindung, die den mindestens einen siliziumstreifen (603, 123) und die Abdeckung (602, 122) verbindet.

6. Anordnung nach Anspruch 1, umfassend mindestens eine Ausformung (801) der Abdeckung (802), die mit der Abdeckung aus einem Stück ausgebildet ist, mit einer lichtundurchlässigen Beschichtung versehen ist und so hoch ist, dass sie die Umhüllungen optisch isoliert.

7. Anordnung nach Anspruch 6, wobei die lichtundurchlässige Beschichtung chromhaltig ist.

8. Verfahren zum Herstellen einer Anordnung mit mindestens zwei benachbart angeordneten lichtemittierenden Halbleiterbauelementen (101, 111),
- bei dem eine, jeweils die zwei lichtemittierenden Halbleiterbauelemente (101, 111) zumindest teilweise umgebende Umhüllung (102, 112) vorgesehen wird, in der eine Konvertersubstanz zur teilweisen oder vollständigen Wellenlängenkonversion der von den mindestens zwei lichtemittierenden Halbleiterbauelementen (101, 111) emittierten Strahlung enthalten ist, und
- bei dem mindestens ein optisches Dämpfelement (103, 603, 701, 801, 123, 133) zwischen die mindestens zwei lichtemittierenden Halbleiterbauelemente (101, 111) eingebracht wird, das die jeweiligen Umhüllungen (102, 112) optisch isoliert, um eine optische Einkopplung einer von mindestens einem der Halbleiterbauelemente (101) emittierten Strahlung in die Umhüllung (102) mindestens eines der anderen Halbleiterbauelemente (111), oder die optische Einkopplung einer von mindestens einer der Umhüllungen (112) emittierten Strahlung in mindestens eine andere der Umhüllungen (102) zu verringern, **gekennzeichnet durch** die Schritte:
- Bereitstellen einer lichtdurchlässigen Abdeckung (122, 602, 702, 802, 132) zum Shutz der mindestens zwei Halbleiterbauelemente (121) ;
- Ausbilden mindestens eines optischen Dämpfelements (123, 603, 701, 801, 133) an der Abdeckung (122, 602, 702, 802, 132), so hoch, dass es die Umhüllungen optisch isoliert; und
- Anordnen der Abdeckung (122, 602, 702, 802, 132), so dass das mindestens eine optische Dämpfelement (123, 603, 701, 801, 133) zwischen den mindestens zwei lichtemittierenden Halbleiterbauelementen (121) liegt, um die jeweiligen Umhüllungen optisch zu isolieren.

9. verfahren nach Anspruch 8,
bei dem das optische Dämpfelement (701) auf die Abdeckung (702) geklebt wird.

10. Verfahren nach Anspruch 8,
bei dem das optische Dämpfelement (701) auf die Abdeckung (702) gedruckt wird.

11. Verfahren nach Anspruch 8,
bei dem die Abdeckung (802) mit mindestens einer Ausbildung (801) geprägt wird.

12. Verfahren nach Anspruch 11,
bei dem die Ausbildung (801) mit einem lichtundurchlässigen Material beschichtet wird.

13. Verfahren nach Anspruch 8,
bei dem das optische Dämpfelement (603, 123) durch anodisches Bonden mit der Abdeckung (602, 122) verbunden wird.

## Claims

1. Arrangement having at least two light-emitting semiconductor components (101, 111, 601) arranged adjacent to one another, comprising:
- an enclosure (102, 112) at least partly surrounding the at least two light-emitting semiconductor components in each case, said enclosure containing a converter substance for the partial or complete wavelength conversion of the radiation emitted by the at least two light-emitting semiconductor components (101, 111),
- at least one optical damping element (103, 603, 701, 801, 123, 133), which is arranged between the at least two light-emitting semiconductor components (101, 111) and optically isolates the respective enclosures (102, 112) in order to reduce an optical coupling-in of a radiation emitted by at least one of the semiconductor components (101) into the enclosure (112) of at least one of the other semiconductor components (111), or the optical coupling-in of a radiation emitted by at least one of the enclosures (102) into at least one other of the enclosures (112), and
- a light-transmissive covering (602, 702, 802, 122, 132) for protecting the at least two semiconductor components (601),
**characterized in that**
- the optical damping element (103, 603, 701, 801, 123, 133) is formed as part of the light-transmissive covering (602, 702, 802, 122, 132).

2. The arrangement according to Claim 1, wherein a body composed of an injection-molded plastic is connected to the covering.

3. The arrangement according to Claim 2, wherein the body is adhesively bonded or printed onto the covering.

4. The arrangement according to Claim 1, comprising at least one silicon strip (603, 123) which is so high that it optically isolates the enclosures.

5. The arrangement according to Claim 4, comprising an anodic bonding connection which connects the at least one silicon strip (603, 123) and the covering (602, 122).

6. The arrangement according to Claim 1, comprising at least one shaped portion (801) of the covering (802), which is formed with the covering from one piece, is provided with a light-opaque coating and is so high that it optically isolates the enclosures.

7. The arrangement according to Claim 6, wherein the light-opaque coating contains chromium.

8. A method for producing an arrangement having at least two light-emitting semiconductor components (101, 111) arranged adjacent to one another,
- in which an enclosure (102, 112) at least partly surrounding the at least two light-emitting semiconductor components (101, 111) in each case is provided, said enclosure containing a converter substance for the partial or complete wavelength conversion of the radiation emitted by the at least two light-emitting semiconductor components (101, 111), and
- in'which at least one optical damping element (103, 603, 701, 801, 123, 133) is introduced between the at least two light-emitting semiconductor components (101, 111), which optically isolates the respective enclosures (102, 112) in order to reduce an optical coupling-in of a radiation emitted by at least one of the semiconductor components (101) into the enclosure (102) of at least one of the other semiconductor components (111), or the optical coupling-in of a radiation emitted by at least one of the enclosures (112) into at least one other of the enclosures (102), **characterized by** the steps of:
- providing a light-transmissive covering (122, 602, 702, 802, 132) for protecting the at least two semiconductor components (121);
- forming at least one optical damping element (123, 603, 701, 801, 133) at the covering (122, 602, 702, 802, 132), so high that it optically isolates the enclosures; and
- arranging the covering (122, 602, 702, 802, 132) such that the at least one optical damping element (123, 603, 701, 801, 133) lies between the at least two light-emitting semiconductor components (121) in order to optically isolate the respective enclosures.

9. The method according to Claim 8, in which the optical damping element (701) is adhesively bonded onto the covering (702).

10. The method according to Claim 8, in which the optical damping element (701) is printed onto the covering (702).

11. The method according to Claim 8, in which the covering (802) is embossed with at least one formation (801).

12. The method according to Claim 11, in which the formation (801) is coated with a light-opaque material.

13. The method according to Claim 8, in which the optical damping element (603, 123) is connected to the covering (602, 122) by anodic bonding.

## Revendications

1. Dispositif comportant au moins deux composants semi-conducteurs électroluminescents juxtaposés (101, 111, 601), comprenant :
- une gaine (102, 112) entourant respectivement au moins partiellement les au moins deux composants semi-conducteurs électroluminescents, dans laquelle est contenue une substance de conversion destinée à effectuer une conversion partielle ou complète de la longueur d'onde du rayonnement émis par les au moins deux composants semi-conducteurs électroluminescents (101, 111),
- au moins un élément d'atténuation optique (103, 603, 701, 801, 123, 133) qui est disposé entre les au moins deux composants semi-conducteurs électroluminescents (101, 111) et qui isole optiquement les gaines respectives (102, 112) afin de réduire un couplage optique d'un rayonnement émis par au moins l'un des composants semi-conducteurs (101) dans la gaine (112) d'au moins l'un des autres composants semi-conducteurs (111), ou le couplage optique d'un rayonnement émis par au moins l'une des gaines (102) dans au moins une autre des gaines (112), et
- un couvercle transparent à la lumière (602, 702, 802, 122, 132) pour protéger les au moins deux composants semi-conducteurs (601),
**caractérisé en ce que**
l'élément d'atténuation optique (103, 603, 701, 801, 123, 133) est réalisé en tant que partie du couvercle transparent à la lumière (602, 702, 802, 122, 132).

2. Dispositif selon la revendication 1, dans lequel un corps constitué d'une matière plastique moulée par injection est relié au couvercle.

3. Dispositif selon la revendication 2, dans lequel le corps est collé ou imprimé sur le couvercle.

4. Dispositif selon la revendication 1, comprenant au moins une bande de silicium (603, 123) suffisamment épaisse pour isoler optiquement les gaines.

5. Dispositif selon la revendication 4, comprenant une liaison par soudage anodique qui relie au moins une bande de silicium (603, 123) au couvercle (602, 122).

6. Dispositif selon la revendication 1, comprenant au moins une formation (801) du couvercle (802) qui est réalisée sous la forme d'une seule pièce avec le couvercle, pourvue d'un revêtement opaque à la lumière et suffisamment épaisse pour isoler optiquement les gaines.

7. Dispositif selon la revendication 6, dans lequel le revêtement opaque à la lumière contient du chrome.

8. Procédé de fabrication d'un dispositif comportant au moins deux composants semi-conducteurs électroluminescents juxtaposés (101, 111),
- dans lequel il est prévu une gaine (102, 112) entourant respectivement au moins partiellement les deux composants semi-conducteurs électroluminescents (101, 111), gaine dans laquelle est contenue une substance de conversion destinée à la conversion partielle ou totale de la longueur d'onde du rayonnement émis par les au moins deux composants semi-conducteurs électroluminescents (101, 111), et
- dans lequel au moins un élément d'atténuation optique (103, 603, 701, 801, 123, 133) est introduit entre les au moins deux composants semi-conducteurs électroluminescents (101, 111), celui-ci isolant optiquement les gaines respectives (102, 112) afin de réduire un couplage optique d'un rayonnement émis par au moins l'un des composants semi-conducteurs (101) dans la gaine (102) d'au moins l'un des autres composants semi-conducteurs (111), ou le couplage optique d'un rayonnement émis par au moins l'une des gaines (112) dans au moins une autre des gaines (102),
**caractérisé par**
les étapes consistant à :
- fournir un couvercle transparent à la lumière (122, 602, 702, 802, 132) pour protéger les au moins deux composants semi-conducteurs (121) ;
- former au moins un élément d'atténuation optique (123, 603, 701, 801, 133) sur le couvercle (122, 602, 702, 802, 132), sur une épaisseur suffisante pour isoler optiquement les gaines ; et
- agencer le couvercle (122, 602, 702, 802, 132) de manière à ce que l'au moins un élément d'atténuation optique (123, 603, 701, 801, 133) se situe entre les au moins deux composants semi-conducteurs électroluminescents (121) afin d'isoler optiquement les gaines respectives.

9. Procédé selon la revendication 8, dans lequel l'élément d'atténuation optique (701) est collé sur le couvercle (702).

10. Procédé selon la revendication 8, dans lequel l'élément d'atténuation optique (701) est imprimé sur le couvercle (702).

11. Procédé selon la revendication 8, dans lequel le couvercle (802) est gravé de manière à présenter au moins une formation (801).

12. Procédé selon la revendication 11, dans lequel la formation (801) est revêtue d'un matériau opaque à la lumière.

13. Procédé selon la revendication 8, dans lequel l'élément d'atténuation optique (603, 123) est relié au couvercle (602, 122) par soudage anodique.
